# EUROPEAN PATENT SPECIFICATION

(11) **EP 2 342 962 B1**
(45) Date of publication and mention of the grant of the patent: **27.06.2018**
(21) Application number: 09822385.2
(22) Date of filing: 23.09.2009
(51) Int. Cl.: H05K 7/20

(54) **REAR DOOR HEAT EXCHANGER TRANSITION FRAME**
ÜBERGANGSRAHMEN FÜR EINEN HINTERTÜR-WÄRMETAUSCHER
CADRE DE TRANSITION POUR ÉCHANGEUR DE CHALEUR DE PORTE ARRIÈRE

(30) Priority: 20.10.2008 US 106691 P; 07.07.2009 US 498434
(43) Date of publication of application: 13.07.2011
(73) Proprietor: Vette Asia, LLC, Pelham, NH 03076 (US)
(72) Inventor: NOVOTNY, Shlomo, Wayland, MA 01778 (US); MENOCHE, John, P, North Smithfield, RI 02896-8163 (US)
(74) Representative: Schön, Christoph
(86) International application number: PCT/US2009/057955
(87) International publication number: WO 2010/047910

(56) References cited:
- US-A- 4 535 386
- US-A- 4 820 885
- US-A- 5 782 546
- US-A1- 2005 204 510
- US-A1- 2006 232 945
- US-A1- 2007 171 613
- US-A1- 2009 225 514
- US-B2- 6 535 382
- US-B2- 6 983 566
- US-B2- 7 385 810

## Description

### FIELD OF THE INVENTION

The invention relates to a system and method to support cooling heat generating components, and more particularly, to a system and method for integrating a liquid cooling door with associated computer equipment racks.

### BACKGROUND OF THE INVENTION

Liquid cooling of electronics cabinets to control heat rise is known. Increases in electronics density are accompanied by increases in heat production for a given volume of electronic equipment. This has reached the point where air conditioning systems are unable to cool computing facilities without supplemental liquid cooling.

Competition among computing providers such as server farms, communications vendors, and data storage centers has generated a need for reliable, scalable cooling solutions as they expand their facilities.

Rear door heat exchangers, such as that available from IBM and described in U.S. Patent No. 7,385,810, are effective at dealing with data center hot-spots and facilitate the deployment of fully loaded racks. They offer space savings and flexibility for sites that have often exceeded their cooling capacity. They decrease the load on air conditioning and, with separate cooling circuits, can provide redundancy and added shut-down time should air conditioning fail. For example, temperatures can climb 2 degrees Centigrade per minute following air conditioning failure, resulting in server shut down and 100 degree Fahrenheit temperatures in less than 15 minutes. Rear door heat exchangers are also typically the most energy efficient data center cooling system.

Existing liquid cooling solutions however, require equipment racks custom designed for liquid heat exchangers. These are expensive and often exceed the needs and budget of start-ups and cost-sensitive operations. Currently, the upgrade options available are limited and operationally prohibitive, often requiring shutting down equipment and replacing the racks housing it. This rack replacement involving shutting down mission critical servers, removing the hardware, and reinstalling the equipment is a very expensive and labor intensive process.

No alternative may exist though, if expansion requires a new rack to accommodate a rear door heat exchanger. Upgrade paths are not normal in the industry. While standardized rack sizes exist, variations prevent direct interchangeability of components such as doors. Hinges and latches are an example of this variability. This lack of interchangeability requires an extensive initial investment for a more advanced rack than may be required at start-up if rear door heat exchangers are anticipated.

US 2007/171613 A1 discloses an air removal unit configured for removing exhaust air from an equipment rack or enclosure which air removal unit includes multiple fans to achieve a high airflow capacity while defining a compact and portable structure. The unit removably installs along an exhaust side of an equipment rack or enclosure to provide capabilities for managing the thermal output of equipment, such as servers, CPUs, communications, internetworking and other types of equipment. The unit includes one or more upper fan modules and one or more lower fan modules positioned below the upper fan modules. The upper and the lower fan modules are arranged in a stacked configuration along the depth of the unit with the lower fan modules positioned in an offset orientation relative to the upper fan modules. The stacked configuration and the offset orientation of the fan modules help to incorporate multiple fans with the unit while maintaining the compact and portable design. The unit is further configured to serve as a door of an equipment rack or enclosure to thereby provide access to the unit and the rack or enclosure during operation. The unit can be incorporated with a ventilation system or a cooling air system associated with an equipment room or data center.

US 2006/232945 A1 discloses an apparatus and a method for facilitating cooling of an electronics rack employing a heat exchange assembly mounted to an outlet door cover hingedly affixed to an air outlet side of the rack. The heat exchange assembly includes a support frame, an air-to-liquid heat exchanger, and first and second perforated planar surfaces covering first and second main sides, respectively, of the air-to-liquid heat exchanger. The heat exchanger is supported by the support frame and includes inlet and outlet plenums disposed adjacent to the edge of the outlet door cover hingedly mounted to the rack. Each plenum is in fluid communication with a respective connect coupling, and the heat exchanger further includes multiple horizontally-oriented heat exchange tube sections each having serpentine cooling channel with an inlet and an outlet coupled to the inlet plenum and outlet plenum, respectively. Fins extend from the heat exchange tube sections.

There is a need therefore, for an efficient, low labor, inexpensive, reliable and scalable apparatus and method for meeting the cooling needs of enterprises operating equipment generating increasingly greater heat loads.

### SUMMARY OF THE INVENTION

A system and method for integrating a liquid cooling door with associated computer equipment racks is disclosed. Transition frame embodiments include replacements for rack hinges and latches, overcoming the lack of standards in this area. The solution enables the purchase of inexpensive air-cooled racks initially, when relatively few components are installed. Then, as rack capacity is reached by adding components resulting in peak heat loads, the existing rack can be retrofitted with a rear door heat exchanger.

Subject matter of the present invention is a transition frame for a cooling system for an equipment rack as claimed in any one of claims 1 to 14. Embodiments include a transition frame for a cooling system for an equipment rack comprising: a top; a bottom; a first side; and a second side; wherein each of the top, bottom, first side and second side has a rack face opposing a door face; wherein the rack face comprises a means for mating/sealing the rack; the door face comprises a means for mating/sealing a cooling door; wherein cooling of equipment in the rack is maintained through the door, and wherein dissimilar dimensions of the rack and the door are accommodated.

Another embodiment provides a transition frame for a cooling system for an equipment rack comprising an integrated component unitary body having a rack face opposing a door face; whereby mismatch of rack and door hinges and latches and dissimilar dimensions of the rack and door are accommodated and cooling of equipment in the rack is maintained through a cooling door adjacent to the transition frame door face.

Yet other embodiments include a transition frame for a cooling system for an equipment rack comprising a top connected to a first side and a second side, the sides connected to a bottom; wherein each of the top, bottom, first side and second side has a rack face opposing a door face; wherein the rack face is adjacent to the equipment rack and operationally connected with the rack; the door face is adjacent a cooling system door and operationally connected with the cooling door; wherein cooling of equipment in the rack is maintained through the door, and wherein dissimilar dimensions of the rack and the door are accommodated characterized in that at least one of the operational connection with the rack and the operational connection with said cooling door comprises threaded fittings-tapped in the transition frame. For other embodiments, the cooling system door is a rear door heat exchanger, and the cooling system door is added without rack replacement and without equipment shut down. In one embodiment, the frame comprises a unitary body. In yet other embodiments, the frame is integrated with the equipment rack, and in others the frame is integrated with the cooling door. Further embodiments provide that at least one of the operational connection with the equipment rack and the operational connection with the cooling door comprises a replacement latch, and at least one of the operational connection with the equipment rack and the operational connection with the cooling door comprises an extendible gasket. In another embodiment, the gasket is conductive, whereby enclosure shielding is maintained. In yet a further embodiment, at least one of the operational connection with the equipment rack and the operational connection with the cooling door comprises at least one replacement hinge. In another, the at least one replacement hinge supports opening angles of up to 270 degrees. In the invention, at least one of the operational connection with the rack and the operational connection with the cooling door comprises threaded fittings-tapped in the transition frame, and at least one of the operational connection with the rack and the operational connection with the cooling door comprises slots. For another, the frame maintains operation of cooling hoses of the rear door heat exchanger.

Other embodiments provide a method of adapting a cooling door to a rack comprising the steps of providing a transition frame for a cooling system for an equipment rack comprising a top connected to a first side and a second side, the sides connected to a bottom; wherein each of the top, bottom, first side and second side has a rack face opposing a door face; wherein the rack face is adjacent the equipment rack and comprises a means for mating with the rack; the door face is adjacent a cooling system
door and comprises a means for mating with the cooling door; wherein cooling of equipment in the rack is maintained through the door, and wherein dissimilar dimensions of the rack and the door are accommodated; and installing the transition frame on at least one of the rack and the door characterized in that at least one of the connection with the rack and the connection with said cooling door comprises threaded fittings-tapped in the transition door. For other embodiments, airflow impedance is maintained. In yet other embodiments, the frame comprises a unitary body, and the frame is integrated with the cooling door. Other embodiments provide that the frame is compliant with European Union directives on restriction of use of certain hazardous substances in electrical and electronic equipment.

Further embodiments include a transition frame; wherein the rack face comprises a means for mating with the rack; the door face comprises a means for mating with the cooling door; and wherein the transition frame comprises threaded fittings-tapped for connection with at least one of the rack and the cooling door.

The features and advantages described herein are not all-inclusive and, in particular, many additional features and advantages will be apparent to one of ordinary skill in the art in view of the drawings, specification, and claims. Moreover, it should be noted that the language used in the specification has been principally selected for readability and instructional purposes, and not to limit the scope of the inventive subject matter.

### BRIEF DESCRIPTION OF THE DRAWINGS

Figure 1 depicts simplified perspective diagrams of multi-component frame 1A, and integrated component frame 1B, configured in accordance with embodiments.
Figure 2 is a simplified perspective diagram of transition frame alignment with a rack and cooling door configured in accordance with an embodiment.
Figure 3 is a diagram of components comprising a first transition frame embodiment configured in accordance with an embodiment of the invention.
Figure 4 is a diagram of components comprising a second transition frame embodiment configured in accordance with an embodiment of the invention.
Figure 5 is a diagram of components comprising a third transition frame embodiment configured in accordance with an embodiment of the invention.
Figure 6 is a diagram of components comprising a fourth transition frame embodiment configured in accordance with an embodiment of the invention.
Figure 7 is a diagram of components comprising a fifth transition frame embodiment configured in accordance with an embodiment of the invention.
Figure 8 is a diagram of components comprising a sixth transition frame embodiment configured in accordance with an embodiment of the invention.
Figure 9 is a simplified diagram of transition frame first and second hinge embodiments configured in accordance with an embodiment of the invention.
Figure 10 is a simplified diagram of a transition frame third hinge embodiment configured in accordance with an embodiment of the invention.
Figure 11 is a simplified perspective diagram of transition frame latch interfaces configured in accordance with embodiments.
Figure 12 is a simplified a perspective diagram of a transition frame integrated with a rack configured in accordance with an embodiment.
Figure 13 is a simplified a perspective diagram of a transition frame integrated with a door configured in accordance with an embodiment.

### DETAILED DESCRIPTION

The invention is susceptible of many embodiments. What follows is illustrative, but not exhaustive of the scope of the invention.

In the description, relative terms such as "horizontal," "vertical," "up," "down," "top" and "bottom" as well as derivatives should be construed to refer to the orientation as then described or as shown in the drawing figure under discussion. These relative terms are for convenience of description and normally are not intended to require a particular orientation. Terms including "inwardly" versus "outwardly," "front" versus "back" and the like are to be interpreted relative to one another or relative to an axis as appropriate. Terms concerning attachments, coupling and the like, such as "connected" and "interconnected," refer to a relationship wherein structures are secured or attached to one another either directly or indirectly through intervening structures, as well as both movable or rigid attachments or relationships, unless expressly described otherwise. The term "operatively connected" refers to such an attachment, coupling or connection that allows the pertinent structures to operate as intended by virtue of that relationship.

The term "electronics cabinet" is used interchangeably with "equipment rack" or "rack" in this application. It refers to a container for heat generating equipment. It may be any housing for containing components of an electronics system or computer system. Components may be standalone computers, power supplies, memory storage devices or communication interfaces, for example. The term heat exchanger is used to define any heat exchange mechanism through which coolant can circulate. It may include one or more discrete heat exchange devices coupled in series or in parallel.

Embodiments of the present invention provide a low- cost addition of liquid cooling to equipment racks, an installation requiring no down time, and an easy upgrade path maintaining investment in racks.

Elements of embodiments include a rack mating interface that is easy to connect and provides thermal benefits such as control of thermal expansion. Door mating interface embodiments provide easy connection, can conduct rack heat to door exchanger, and control thermal expansion.

Heat exchanger door hose configurations are accommodated by the transition frame rails and air flow control, including air flow impedance, is maintained.

Embodiments provide size adaptability to variations in rack height and or width. For example, various embodiments can support widths from approximately 25 to 35 inches and heights from approximately 76 to 83 inches. Transition frame hinge embodiments support locking, can hold the door open, and provide auto-opening. Hinge embodiments support opening angles of up to 270 degrees.

Sealing methods enable easy installation, are ultra-reliable, and maintain thermal control. In embodiments, conductive gaskets support electromagnetic interference (EMI) protection while maintaining the plenum function of the door housing to direct air through the heat exchanger. Gasket examples include Holland Shielding Systems BV Conductive Rubber 5750. In other embodiments, foam gaskets are used. Latch mechanism embodiments provide: an even gap, compression of the sealing gasket, ensure EMI control, airflow performance, and maintain environmental integrity of the enclosure. Embodiments provide narrow gaps between movable components of approximately 1/8 inch or less when closed.

Connections include, by nonlimiting example, bolts, screws, slide fittings, clamps, grommets, adhesive, interlocking fingers, mating channel, and surrounding gasket. In embodiments, screws affix to threaded fittings-tapped in the transition frame. No special modification is necessary to use transition frames. Transition frame embodiments provide for mismatches between rack and door hinges by supplying compatible replacement components. Embodiments are compliant with European Union directives on the restriction of the use of certain hazardous substances in electrical and electronic equipment. In particular, Directive 2002/95/EC on the Restriction of the Use of certain Hazardous Substances in Electrical and Electronic Equipment (RoHS) as of June 15, 2009, providing that products not contain lead, cadmium, mercury, hexavalent chromium, polybrominated biphenyls (PBB) or polybrominated diphenyl ethers (PBDE) (Article 4(1)). This controls risk during fabrication and reduces personnel and disposal hazards while expanding markets.

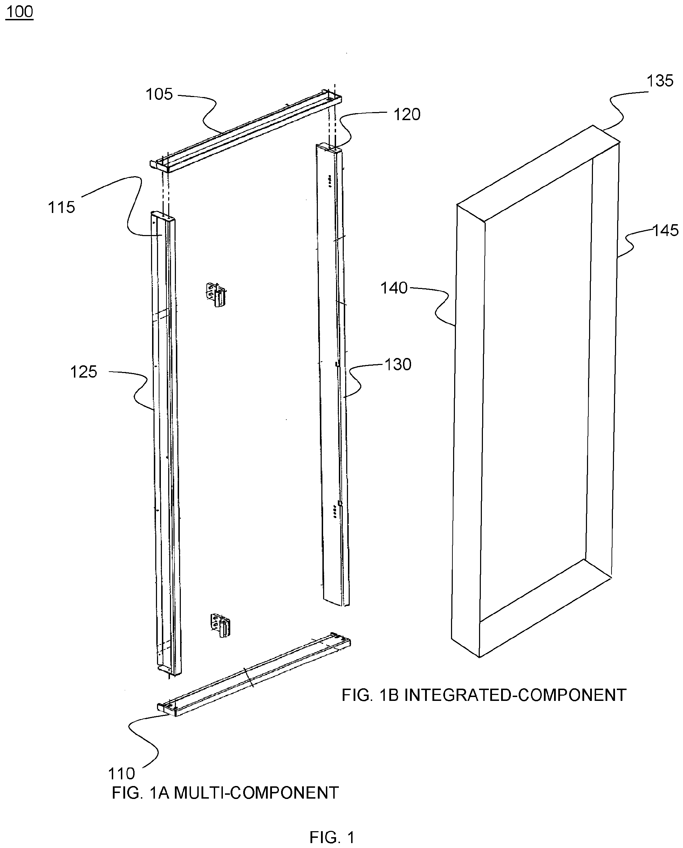

**Figure 1** presents simplified perspective diagrams **100** of embodiments of multi-component **1A**, and integrated unitary component **1B,** transition frames. In **Figure 1A**, top **105,** bottom **110,** first side **115,** and second side **120** are configured to form a frame having rack face **125** and door face **130.** Alternatively, the frame can be comprised of a single, integrated unitary, piece **135** as in **Figure 1B** having rack face **140** and door face **145.**

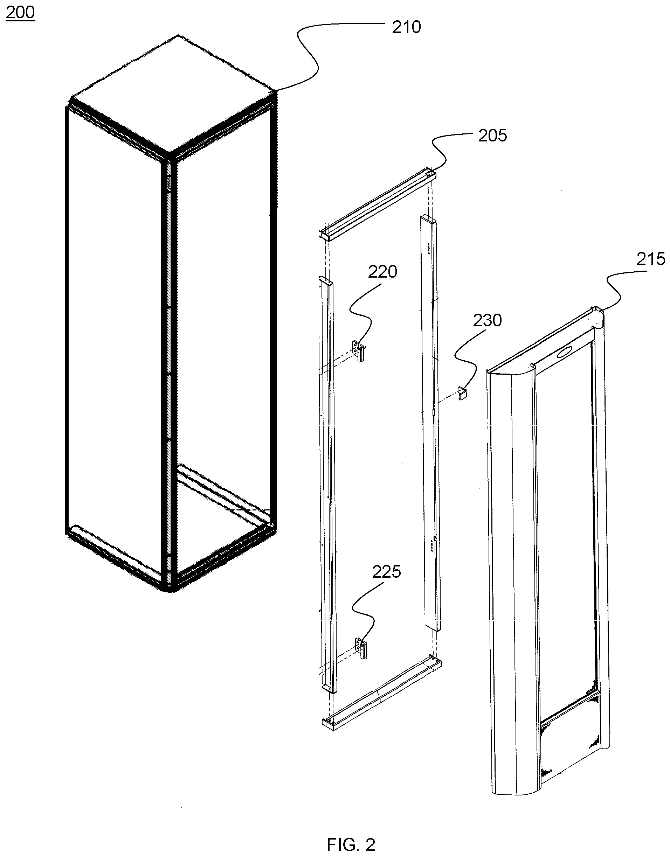

**Figure 2** is a simplified perspective diagram **200** of transition frame **205** alignment with rack **210** and cooling door **215.** Embodiments of transition frame **205** direct airflow from the rack **210** through to heat exchanger door **215.** The frame is depicted with hinges **220** and **225** and latch **230.** The frame mates and seals rack and door peripheries. It provides hinge mounts for the heat exchanger door and supports coolant hoses without interference. Frame rail configurations can provide adjustment to fit multiple racks with multiple doors.

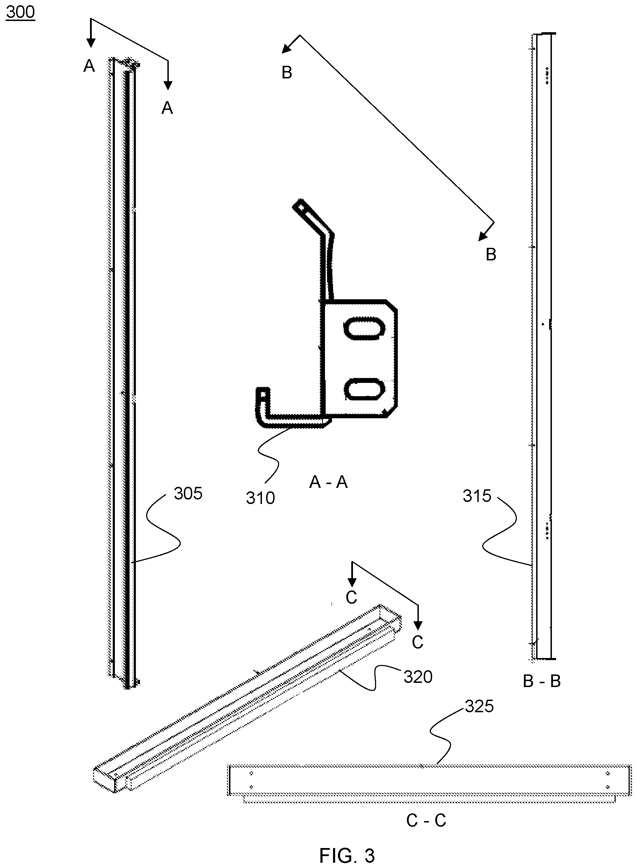

**Figure 3** is a diagram of components comprising a first transition frame embodiment **300** depicting vertical side **305** and cross section A-A **310** of vertical side **305.** Second view **315** of vertical side depicts view B-B of section **310.** Perspective view of horizontal side **320** is also shown in orthogonal view C-C **325.**

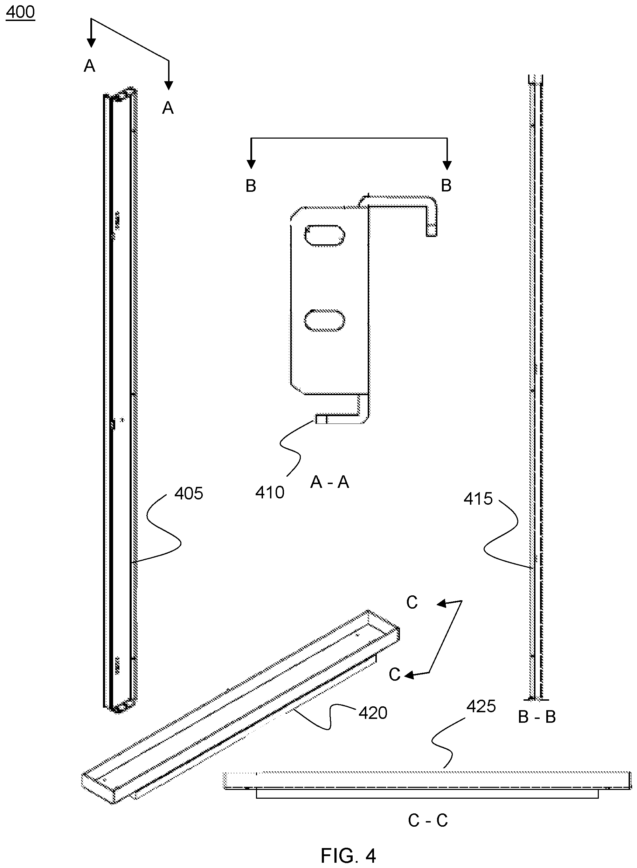

**Figure 4** is a diagram of components comprising a second transition frame embodiment **400** depicting vertical side **405** and cross section A-A **410** of vertical side **405.** Second view **415** of vertical side depicts view B-B of section **410.** Perspective view of horizontal side **420** is also shown in orthogonal view C-C **425.**

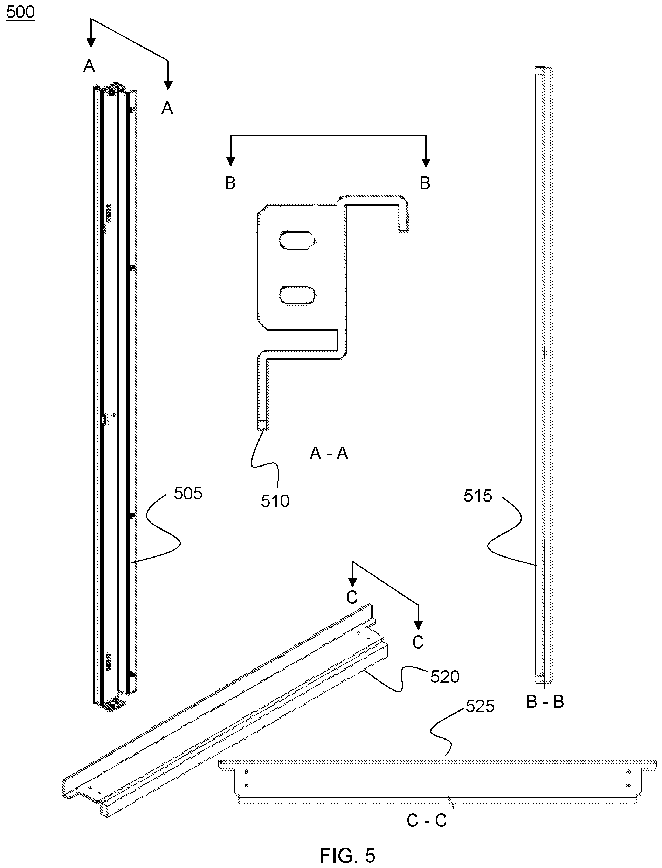

**Figure 5** is a diagram of components comprising a third transition frame embodiment **500** depicting vertical side **505** and cross section A-A **510** of vertical side **505.** Second view **515** of vertical side depicts view B-B of section **510.** Perspective view of horizontal side **520** is also shown in orthogonal view C-C **525.**

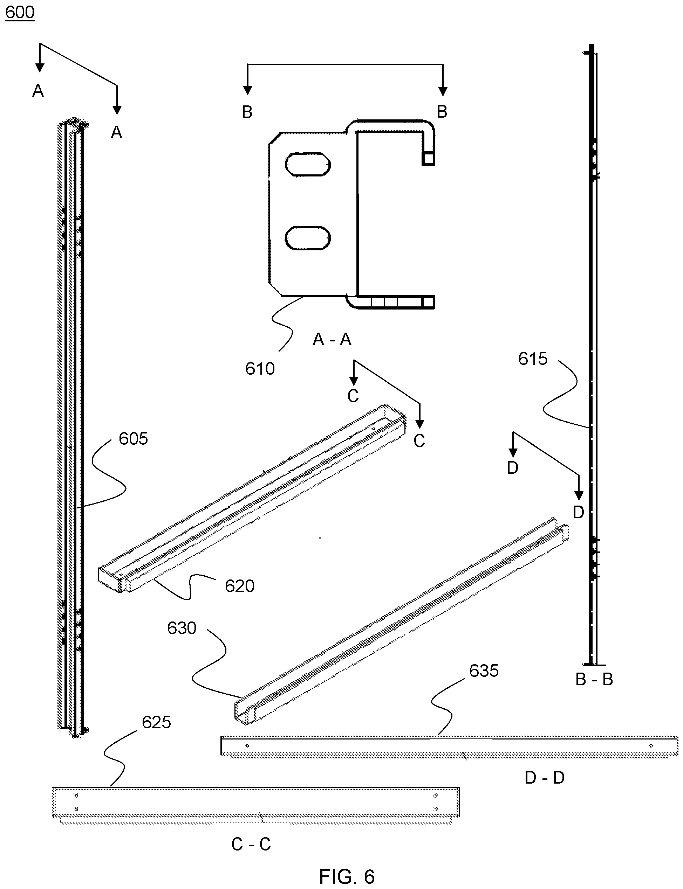

**Figure 6** is a diagram of components comprising a fourth transition frame embodiment **600** depicting vertical side **605** and cross section A-A **610** of vertical side **605.** Second view **615** of vertical side depicts view B-B of section **610.** Perspective view of horizontal side **620** is also shown in orthogonal plan view C-C **625.** Perspective view of horizontal side **630** is also shown in orthogonal view D-D **635.**

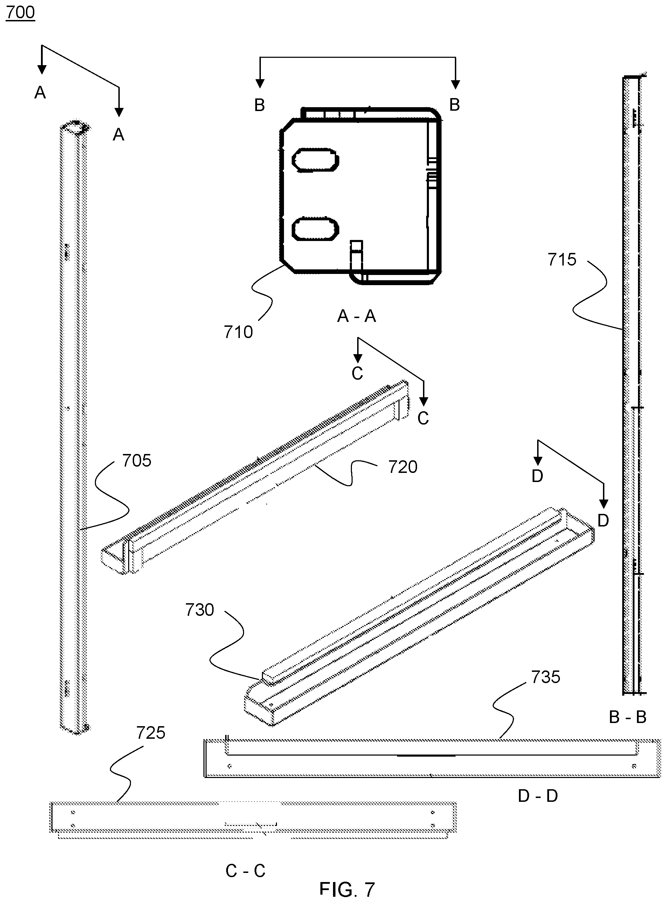

**Figure 7** is a diagram of components comprising a fifth transition frame embodiment **700** depicting vertical side **705** and cross section A-A **710** of vertical side **705.** Second view **715** of vertical side depicts view B-B of section **710.** Perspective view of horizontal side **720** is also shown in orthogonal plan view C-C **725.** Perspective view of horizontal side **730** is also shown in orthogonal view D-D **735.**

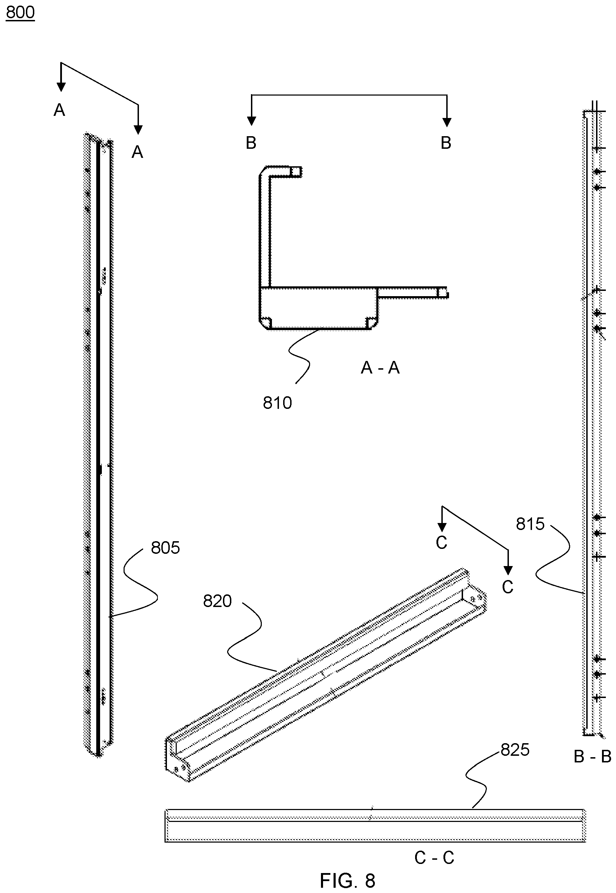

**Figure 8** is a diagram of components comprising a sixth transition frame embodiment **800** depicting vertical side **805** and cross section A-A **810** of vertical side **805.** Second view **815** of vertical side depicts view B-B of section **810.** Perspective view of horizontal side **820** is also shown in orthogonal view C-C **825.**

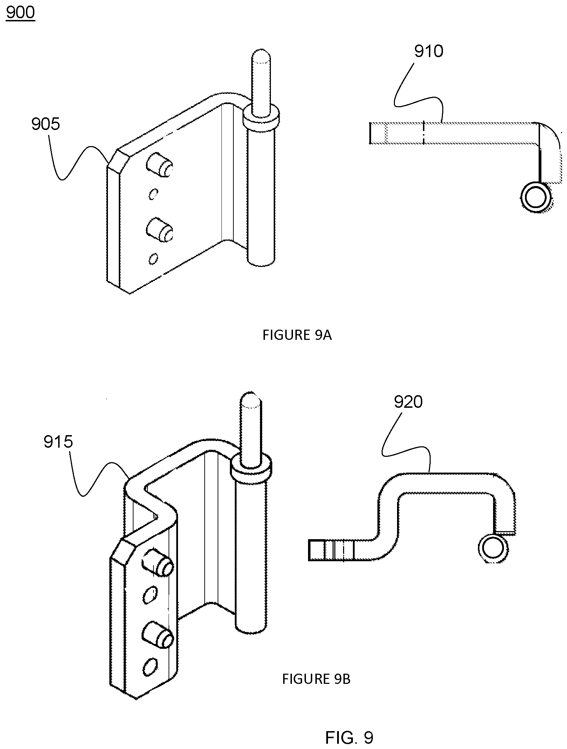

**Figure 9** is a simplified diagram of transition frame hinge interface embodiments **900.** A first transition frame hinge interface embodiment is identified in **9A**. First hinge component is shown in perspective **905,** and orthogonal view **910.** Note that hinge pin length is varied in embodiments with the top or bottom hinge's pin being longer to facilitate attachment alignment. A second transition frame hinge interface embodiment is identified in **9B.** Second hinge component is shown in perspective **915,** and orthogonal view **920.** Note again that hinge pin length is varied in embodiments with the top or bottom hinge's pin being longer to facilitate attachment alignment. Transition frame embodiments provide for mismatches between rack and door hinges by supplying compatible replacement components.

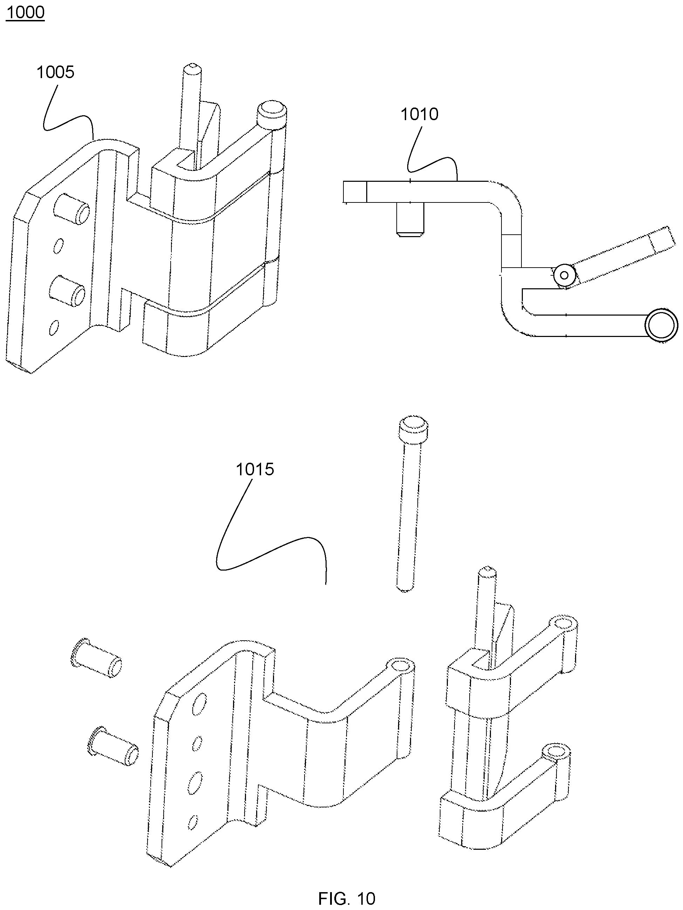

**Figure 10** is a simplified perspective diagram of a third transition frame hinge interface embodiment **1000.** Third hinge component is shown in perspective **1005,** and orthogonal view **1010.** Exploded view **1015** depicts individual components comprising hinge embodiments. Embodiments support opening angles of up to 270 degrees.

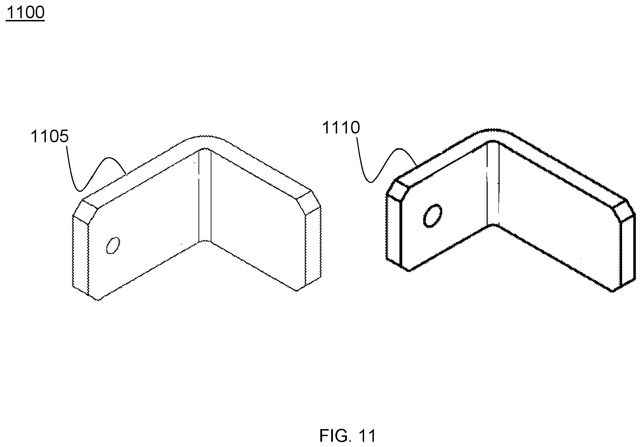

**Figure 11** is a simplified perspective diagram of transition frame latch interface embodiments **1100.** First **1105,** and second, **1110,** latch components are shown in perspective. As with the transition frame hinge interface, transition frame embodiments provide for mismatches between rack and door latches by supplying compatible replacement components.

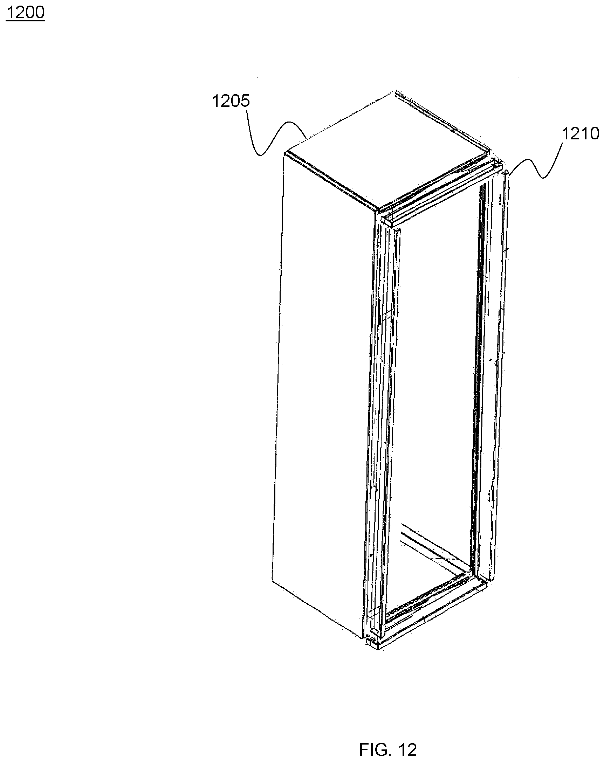

**Figure 12** is a simplified perspective diagram of an embodiment of a transition frame integrated with a rack **1200** showing equipment rack **1205** with transition frame **1210** integrated with its face to accommodate cooling door (not shown). This provides initially for a rack unit to accommodate a cooling door.

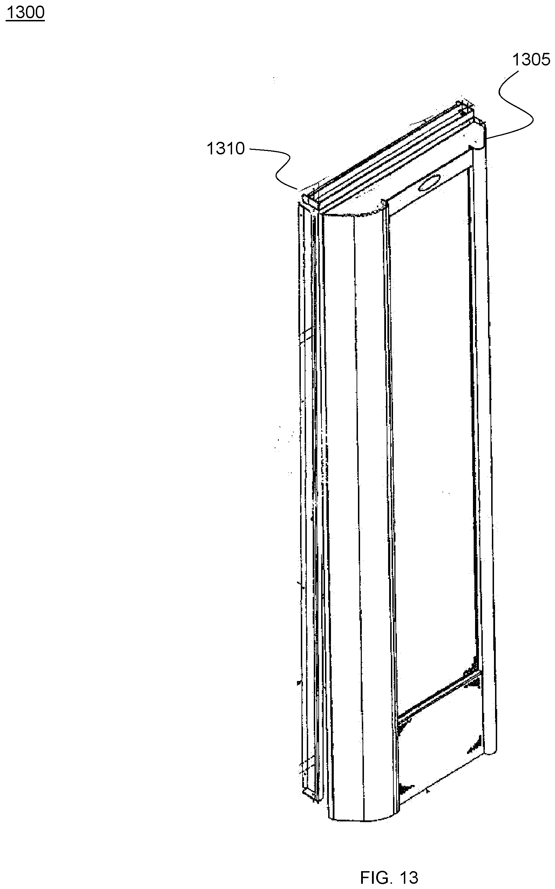

**Figure 13** is a simplified perspective diagram of an embodiment of a transition frame integrated with a door **1300** showing cooling door **1305** with transition frame **1310** integrated with its face to accommodate equipment rack (not shown). This provides initially for a door unit to accommodate an equipment rack.

Other and various embodiments will be readily apparent to those skilled in the art, from this description, figures, and the claims that follow.

The foregoing description of the embodiments of the invention has been presented for the purposes of illustration and description. It is not intended to be exhaustive or to limit the invention to the precise form disclosed. Many modifications and variations are possible in light of this disclosure. It is intended that the scope of the invention be limited not by this detailed description, but by the claims appended hereto.

## Claims

1. A transition frame for a cooling system (205, 300, 400, 500, 600, 700, 800, 1210, 1310) for an equipment rack comprising:
a top (105) connected to a first side (115) and a second side (120), said sides connected to a bottom (110);
wherein each of said top (115), said bottom (110), said first side (115) and said second side (120) has a rack face (125, 140) opposing a door face (130, 145);
wherein said rack face (125, 140) is adjacent said equipment rack (210) and operationally connected with said rack (210);
said door face (130) is adjacent a cooling system door and operationally connected with said cooling door (215, 1305);
wherein cooling of equipment in said rack (210) is maintained through said door (215, 1305), and
wherein dissimilar dimensions of said rack (210) and said door (215, 1305) are accommodated **characterized in that** at least one of said operational connection with said rack (210) and said operational connection with said cooling door (215, 1305) comprises threaded fittings-tapped in said transition frame (205, 300, 400, 500, 600, 700, 800, 1210, 1310).

2. The transition frame (205, 300, 400, 500, 600, 700, 800, 1210, 1310) of claim 1 wherein said cooling system door is a rear door heat exchanger.

3. The transition frame (205, 300, 400, 500, 600, 700, 800, 1210, 1310) of claim 1 or 2 wherein said cooling system door is added without rack replacement and without equipment shut down.

4. The transition frame (205, 300, 400, 500, 600, 700, 800, 1210, 1310) of any one of claims 1 to 3 wherein said frame (205, 300, 400, 500, 600, 700, 800, 1210, 1310) comprises a unitary body.

5. The transition frame (205, 300, 400, 500, 600, 700, 800, 1210, 1310) of any one of claims 1 to 4 wherein said frame (205, 300, 400, 500, 600, 700, 800, 1210, 1310) is integrated with said equipment rack (210) and/or with said cooling door (215, 1305).

6. The transition frame (205, 300, 400, 500, 600, 700, 800, 1210, 1310) of any one of claims 1 to 5 wherein at least one of said operational connection with said equipment rack (210) and said operational connection with said cooling door (215, 1305) comprises a replacement latch.

7. The transition frame (205, 300, 400, 500, 600, 700, 800, 1210, 1310) any one of claims 1 to 6 wherein at least one of said operational connection with said equipment rack (210) and said operational connection with said cooling door (215, 1305) comprises an extendible gasket which optionally is conductive.

8. The transition frame (205, 300, 400, 500, 600, 700, 800, 1210, 1310) of any one of claims 1 to 7 wherein at least one of said operational connection with said equipment rack (210) and said operational connection with said cooling door (215, 1305) comprises at least one replacement hinge, said hinge optionally supporting opening angles of up to 270 degrees.

9. The transition frame (205, 300, 400, 500, 600, 700, 800, 1210, 1310) of any one of claims 1 to 8 wherein at least one of said operational connection with said rack (210) and said operational connection with said cooling door (215, 1305) comprises slots.

10. The transition frame (205, 300, 400, 500, 600, 700, 800, 1210, 1310) of any one of claims 2 to 9 wherein said frame (205, 300, 400, 500, 600, 700 ,800, 1210, 1310) maintains operation of cooling hoses of said rear door heat exchanger.

11. A method of adapting a cooling door (215, 1305) to a rack comprising the steps of:
providing a transition frame (205, 300, 400, 500, 600, 700, 800, 1210, 1310) for a cooling system for an equipment rack comprising : a top (105) connected to a first side (115) and a second side (120), said sides connected to a bottom (110);
wherein each of said top (105), said bottom (110), said first side (115) and said second side (120) has a rack face (125, 140) opposing a door face (130, 145);
wherein said rack face (125, 140) is adjacent said equipment rack (210) and comprises a means for mating with said rack (210); said door face (130, 145) is adjacent a cooling system door and comprises a means for mating with said cooling door (215, 1305); wherein cooling of equipment in said rack (210) is maintained through said door (215, 1305), and wherein dissimilar dimensions of said rack (210) and said door (215, 1305) are accommodated; and
installing said transition frame (205, 300, 400, 500, 600, 700, 800, 1210, 1310) on at least one of said rack (210) and said door (215, 1305) **characterized in that** at least one of the connection with said rack (210) and the connection with said cooling door (215, 1305) comprises threaded fittings-tapped in said transition frame.

12. The method of claim 11 wherein airflow impedance is maintained.

13. The method of claim 11 or 12 wherein said frame comprises a unitary body and/or is integrated with said cooling door (215, 1305).

14. The transition frame (205, 300, 400, 500, 600, 700, 800, 1210, 1310) of claim 1 wherein said rack face (125, 140) comprises a means for mating with said rack (210);
said door face (130, 145) comprises a means for mating with said cooling door (215, 1305); and
wherein the transition frame (205, 300, 400, 500, 600, 700, 800, 1210, 1310) comprises threaded fittings-tapped for connection with at least one of said rack (210) and said cooling door, wherein cooling of equipment in said rack is maintained through said door (215, 1305).

## Patentansprüche

1. Übergangsrahmen für ein Kühlsystem (205, 300, 400, 500, 600, 700, 800, 1210, 1310) für ein Equipment-Gehäuse, umfassend:
ein Oberteil (105), das an eine erste Seite (115) und eine zweite Seite (120) angeschlossen ist, wobei die Seiten an ein Unterteil (110) angeschlossen sind;
wobei jedes von Oberteil (115), Unterteil (110), erster Seite (115) und zweiter Seite (120) eine Gehäusestirnfläche (125, 140) gegenüberliegend zu einer Türstirnfläche (130, 145) aufweist;
wobei die Gehäusestirnfläche (125, 140) an das Equipment-Gehäuse (210) angrenzt und operativ mit dem Gehäuse (210) verbunden ist;
die Türstirnfläche (130) an eine Kühlsystemtür angrenzt und operativ mit der Kühltür (215, 1305) verbunden ist;
wobei das Kühlen des Equipments in dem Gehäuse (210) durch die Tür (215, 1305) aufrechterhalten wird, und
wobei unterschiedliche Abmessungen des Gehäuses (210) und der Tür (215, 1305) ausgeglichen werden, **dadurch gekennzeichnet, dass** mindestens eine von der operativen Verbindung mit dem Gehäuse (210) und der operativen Verbindung mit der Kühltür (215, 1305) in dem Übergangsrahmen (205, 300, 400, 500, 600, 700, 800, 1210, 1310) befindliche Gewindeverschraubungen aufweist.

2. Übergangsrahmen (205, 300, 400, 500, 600, 700, 800, 1210, 1310) nach Anspruch 1, wobei die Kühlsystemtür ein Hintertür-Wärmeaustauscher ist.

3. Übergangsrahmen (205, 300, 400, 500, 600, 700, 800, 1210, 1310) nach Anspruch 1 oder Anspruch 2, wobei die Kühlsystemtür ohne Ersetzen des Gehäuses und ohne Stilllegen des Equipments hinzugefügt wird.

4. Übergangsrahmen (205, 300, 400, 500, 600, 700, 800, 1210, 1310) nach einem der Ansprüche 1 bis 3, wobei der Rahmen (205, 300, 400, 500, 600, 700, 800, 1210, 1310) einen unitären Körper aufweist.

5. Übergangsrahmen (205, 300, 400, 500, 600, 700, 800, 1210, 1310) nach einem der Ansprüche 1 bis 4, wobei der Rahmen (205, 300, 400, 500, 600, 700, 800, 1210, 1310) in das Equipment-Gehäuse (210) und/oder die Kühltür (215, 1305) integriert ist.

6. Übergangsrahmen (205, 300, 400, 500, 600, 700, 800, 1210, 1310) nach einem der Ansprüche 1 bis 5, wobei mindestens eine von der operativen Verbindung mit dem Equipment-Gehäuse (210) und der operativen Verbindung mit der Kühltür (215, 1305) eine Ersatzverriegelung umfasst.

7. Übergangsrahmen (205, 300, 400, 500, 600, 700, 800, 1210, 1310) nach einem der Ansprüche 1 bis 6, wobei mindestens eine von der operativen Verbindung mit dem Equipment-Gehäuse (210) und der operativen Verbindung mit der Kühltür (215, 1305) eine dehnbare Dichtung umfasst, die optional leitfähig ist.

8. Übergangsrahmen (205, 300, 400, 500, 600, 700, 800, 1210, 1310) nach einem der Ansprüche 1 bis 7, wobei mindestens eine von der operativen Verbindung mit dem Equipment-Gehäuse (210) und der operativen Verbindung mit der Kühltür (215, 1305) mindestens ein Ersatzscharnier umfasst, wobei das Scharnier optional Öffnungswinkel bis zu 270 Grad unterstützt.

9. Übergangsrahmen (205, 300, 400, 500, 600, 700, 800, 1210, 1310) nach einem der Ansprüche 1 bis 8, wobei mindestens eine von der operativen Verbindung mit dem Gehäuse (210) und der operativen Verbindung mit der Kühltür (215, 1305) Schlitze aufweist.

10. Übergangsrahmen (205, 300, 400, 500, 600, 700, 800, 1210, 1310) nach einem der Ansprüche 2 bis 9, wobei der Rahmen (205, 300, 400, 500, 600, 700, 800, 1210, 1310) den Betrieb von Kühlschläuchen des Hintertür-Wärmeaustauschers aufrechterhält.

11. Verfahren zur Anpassung einer Kühltür (215, 1305) an ein Gehäuse, umfassend die Schritte:
Bereitstellen eines Übergangsrahmens (205, 300, 400, 500, 600, 700, 800, 1210, 1310) für ein Kühlsystem für ein Equipment-Gehäuse, umfassend: ein Oberteil (105), das an eine erste Seite (115) und eine zweite Seite (120) angeschlossen ist, wobei die Seiten an ein Unterteil (110) angeschlossen sind; wobei jedes von Oberteil (105), Unterteil (110), erster Seite (115) und zweiter Seite (120) eine Gehäusestirnfläche (125, 140) gegenüberliegend zu einer Türstirnfläche (130, 145) aufweist; wobei die Gehäusestirnfläche (125, 140) an das Equipment-Gehäuse (210) angrenzt und ein Mittel zum Zusammenfügen mit dem Gehäuse (210) umfasst; die Türstirnfläche (130, 145) an eine Kühlsystemtür angrenzt und ein Mittel zum Zusammenfügen mit der Kühltür (215, 1305) umfasst; wobei die Kühlung des Equipments in dem Gehäuse (210) durch die Tür (215, 1305) aufrechterhalten wird und wobei unterschiedliche Abmessungen des Gehäuses (210) und der Tür (215, 1305) ausgeglichen werden; und
Installieren des Übergangsrahmens (205, 300, 400, 500, 600, 700, 800, 1210, 1310) auf mindestens einem von Gehäuse (210) und Tür (215, 1305), **dadurch gekennzeichnet, dass** mindestens eine von der Verbindung mit dem Gehäuse (210) und der Verbindung mit der Kühltür (215, 1305) in dem Übergangsrahmen befindliche Gewindeverschraubungen aufweist.

12. Verfahren nach Anspruch 11, wobei die Luftstromimpedanz aufrechterhalten wird.

13. Verfahren nach Anspruch 11 oder 12, wobei der Rahmen einen unitären Körper umfasst und/oder in die Kühltür (215, 1305) integriert ist.

14. Übergangsrahmen (205, 300, 400, 500, 600, 700, 800, 1210, 1310) nach Anspruch 1, wobei
die Gehäusestirnfläche (125, 140) ein Mittel zum Zusammenfügen mit dem Gehäuse aufweist (210);
die Türstirnfläche (130, 145) ein Mittel zum Zusammenfügen mit der Kühltür (215, 1305) aufweist, und
wobei der Übergangsrahmen (205, 300, 400, 500, 600, 700, 800, 1210, 1310) zur Verbindung mit mindestens einem von Gehäuse (210) und Kühltür Gewindeverschraubungen umfasst, wobei die Kühlung des Equipments im Gehäuse durch die Tür (215, 1305) aufrechterhalten wird.

## Revendications

1. Cadre de transition pour un système de refroidissement (205, 300, 400, 500, 600, 700, 800, 1210, 1310) pour un bâti d'équipement comprenant :
une partie supérieure (105) reliée à un premier côté (115) et à un second côté (120), lesdits côtés étant reliés à une partie inférieure (110) ;
dans lequel chacun de ladite partie supérieure (115), de ladite partie inférieure (110), dudit premier côté (115) et dudit second côté (120) possède une face de bâti (125, 140) s'opposant à la face de porte (130, 145) ;
dans lequel ladite face de bâti (125, 140) est adjacente audit bâti d'équipement (210) et est reliée de manière fonctionnelle audit bâti (210) ;
ladite face de porte (130) est adjacente à une porte de système de refroidissement et est reliée de manière fonctionnelle à ladite porte de refroidissement (215, 1305) ;
dans lequel le refroidissement de l'équipement dans ledit bâti (210) est maintenu grâce à ladite porte (215, 1305), et
dans lequel des dimensions différentes dudit bâti (210) et de ladite porte (215, 1305) sont accommodées **caractérisé en ce qu'**au moins un dudit raccordement fonctionnel avec ledit bâti (210) et ledit raccordement fonctionnel avec ladite porte de refroidissement (215, 1305) comprend des raccords filetés captés dans ledit cadre de transition (205, 300, 400, 500, 600, 700, 800, 1210, 1310).

2. Cadre de transition (205, 300, 400, 500, 600, 700, 800, 1210, 1310) selon la revendication 1, dans lequel ladite porte de système de refroidissement consiste en un échangeur de chaleur de porte arrière.

3. Cadre de transition (205, 300, 400, 500, 600, 700, 800, 1210, 1310) selon la revendication 1 ou la revendication 2, dans lequel ladite porte de système de refroidissement est ajoutée sans effectuer le remplacement du bâti et sans arrêter l'équipement.

4. Cadre de transition (205, 300, 400, 500, 600, 700, 800, 1210, 1310) selon l'une quelconque des revendications 1 à 3, dans lequel ledit cadre (205, 300, 400, 500, 600, 700, 800, 1210, 1310) est constitué d'un corps unitaire.

5. Cadre de transition (205, 300, 400, 500, 600, 700, 800, 1210, 1310) selon l'une quelconque des revendications 1 à 4, dans lequel ledit cadre (205, 300, 400, 500, 600, 700, 800, 1210, 1310) est intégré audit bâti d'équipement (210) et/ou à ladite porte de refroidissement (215, 1305).

6. Cadre de transition (205, 300, 400, 500, 600, 700, 800, 1210, 1310) selon l'une quelconque des revendications 1 à 5, dans lequel au moins un dudit raccordement fonctionnel avec ledit bâti d'équipement (210) et dudit raccordement fonctionnel avec ladite porte de refroidissement (215, 1305) comprend un loquet de remplacement.

7. Cadre de transition (205, 300, 400, 500, 600, 700, 800, 1210, 1310) selon l'une quelconque des revendications 1 à 6, dans lequel au moins un dudit raccordement fonctionnel avec ledit bâti d'équipement (210) et dudit raccordement fonctionnel avec ladite porte de refroidissement (215, 1305) comprend un joint d'étanchéité extensible qui est éventuellement conducteur.

8. Cadre de transition (205, 300, 400, 500, 600, 700, 800, 1210, 1310) selon l'une quelconque des revendications 1 à 7, dans lequel au moins un dudit raccordement fonctionnel avec ledit bâti d'équipement (210) et dudit raccordement fonctionnel avec ladite porte de refroidissement (215, 1305) comprend au moins une charnière de placement, ladite charnière supportant éventuellement l'ouverture d'angle jusqu'à 270 degrés.

9. Cadre de transition (205, 300, 400, 500, 600, 700, 800, 1210, 1310) selon l'une quelconque des revendications 1 à 8, dans lequel au moins un dudit raccordement fonctionnel avec ledit bâti d'équipement (210) et dudit raccordement fonctionnel avec ladite porte de refroidissement (215, 1305) comprend des fentes.

10. Cadre de transition (205, 300, 400, 500, 600, 700, 800, 1210, 1310) selon l'une quelconque des revendications 2 à 9, dans lequel ledit cadre (205, 300, 400, 500, 600, 700, 800, 1210, 1310) assure le fonctionnement de tuyaux de refroidissement dudit échangeur de chaleur de porte arrière.

11. Procédé permettant d'adapter une porte de refroidissement (215, 1305) à un bâti comprenant les étapes :
de fourniture d'un cadre de transition (205, 300, 400, 500, 600, 700, 800, 1210, 1310) pour un système de refroidissement pour un bâti d'équipement comprenant : une partie supérieure (105) reliée à un premier côté (115) et à un second côté (120), lesdits côtés étant reliés à une partie inférieure (110) ; dans lequel chacun de ladite partie supérieure (105), de ladite partie inférieure (110), dudit premier côté (115) et dudit second côté (120) possède une face de bâti (125, 140) s'opposant à la face de porte (130, 145) ; dans lequel ladite face de bâti (125, 140) est adjacente audit bâti d'équipement (210) et comprend un moyen d'accouplement audit bâti (210) ; ladite face de porte (130, 145) est adjacente à une porte de système de refroidissement et comprend un moyen d'accouplement à ladite porte de refroidissement (215, 1305) ;
dans lequel le refroidissement de l'équipement dans ledit bâti (210) est maintenu grâce à ladite porte (215, 1305), et dans lequel des dimensions différentes dudit bâti (210) et de ladite porte (215, 1305) sont accommodées ; et
d'installation dudit cadre de transition (205, 300, 400, 500, 600, 700, 800, 1210, 1310) sur au moins un dudit bâti (210) et de ladite porte refroidissement (215, 1305) **caractérisé en ce qu'**au moins un du raccordement audit bâti (210) et du raccordement à ladite porte de refroidissement (215, 1305) comprend des raccords filetés captés dans ledit cadre de transition.

12. Procédé selon la revendication 11, dans lequel une impédance du débit d'air est maintenue.

13. Procédé selon la revendication 11 ou la revendication 12, dans lequel ledit cadre comprend un corps unitaire et/ou est intégré à ladite porte de refroidissement (215, 1305).

14. Cadre de transition (205, 300, 400, 500, 600, 700, 800, 1210, 1310) selon la revendication 1, dans lequel ladite face de bâti (125, 140) comprend un moyen d'accouplement audit bâti (210) ;
ladite face de porte (130, 145) comprend un moyen d'accouplement à ladite porte de refroidissement (215, 1305) ; et
dans lequel le cadre de transition (205, 300, 400, 500, 600, 700, 800, 1210, 1310) comprend des raccords filetés captés pour un raccordement avec au moins un dudit bâti (210) et de ladite porte de refroidissement, dans lequel le refroidissement de l'équipement dans ledit bâti est maintenu grâce à ladite porte (215, 1305).
